# EUROPEAN PATENT APPLICATION

(11) **EP 2 814 075 A1**
(43) Date of publication of application: **17.12.2014**
(21) Application number: 13746130.7
(22) Date of filing: 07.02.2013
(51) Int. Cl.: H01L 51/42, H01L 31/072

(54) **ORGANIC THIN FILM SOLAR CELL**

(30) Priority: 07.02.2012 JP 2012024451; 12.07.2012 JP 2012156824
(71) Applicant: Sekisui Chemical Co., Ltd., Osaka-shi, Osaka 530-0047 (JP)
(72) Inventor: HAYAKAWA Akinobu, Mishima-gun Osaka 618-0021 (JP); ITO Kazushi, Mishima-gun Osaka 618-0021 (JP); SUN Ren-de, Mishima-gun Osaka 618-0021 (JP)
(74) Representative: Hart-Davis, Jason
(86) International application number: PCT/JP2013/052794
(87) International publication number: WO 2013/118794

(57) **Abstract**

The present invention aims to provide an organic thin-film solar cell that has a high photoelectric conversion efficiency and excellent durability. The present invention relates to an organic thin-film solar cell including a photoelectric conversion layer, wherein the photoelectric conversion layer includes a portion containing a sulfide of a Group 15 element in the periodic table and a portion containing a donor-acceptor organic semiconductor, and the portion containing a sulfide of a Group 15 element in the periodic table and the portion containing a donor-acceptor organic semiconductor are in contact with each other.

## Description

### TECHNICAL FIELD

The present invention relates to an organic thin-film solar cell that has a high photoelectric conversion efficiency and excellent durability.

### BACKGROUND ART

Photoelectric conversion elements have been developed which include a laminated body of a plurality of kinds of semiconductors and electrodes disposed on both sides of the laminated body. Instead of such a laminated body, use of a composite film produced by mixing a plurality of kinds of semiconductors has also been examined. In such photoelectric conversion elements, each semiconductor acts as a P-type semiconductor or an N-type semiconductor. Photocarriers (electron-hole pairs) are generated by photoexcitation in the P-type semiconductor or N-type semiconductor so that electrons and holes move through the N-type semiconductor and P-type semiconductor, respectively, to create an electric field.

Most photoelectric conversion elements for practical use nowadays are inorganic solar cells produced by use of inorganic semiconductors formed of silicon or other materials. Unfortunately, production of inorganic solar cells is costly, and upsizing is difficult, which limits the range of applications. Thus, organic solar cells produced by use of organic semiconductors, instead of inorganic semiconductors, are attracting interest.

Most organic solar cells include fullerenes. Fullerenes are known to act mainly as an N-type semiconductor. For example,

Patent Literature 1 describes a semiconductor hetero-junction film that includes an organic compound which is to act as a P-type semiconductor and fullerenes. However, organic solar cells produced by use of a fullerene are known to deteriorate due to the fullerene (see, for example, Non Patent Literature 1). It is thus necessary to select materials having higher durability than fullerenes.

Few organic semiconductors are excellent enough to replace fullerenes. Thus, studies have been made on organic solar cells in which an inorganic semiconductor is used instead of a fullerene together with an organic semiconductor. Zinc oxide, titanium oxide, or similar materials are used as an inorganic semiconductor, for example. Such an organic solar cell is described in, for example, Patent Literature 2. The organic solar cell includes an active layer containing an organic electron donor and a compound semiconductor crystal between two electrodes. Unfortunately, the organic solar cell fails to achieve sufficient durability even if zinc oxide, titanium oxide, or similar materials are used. Moreover, it has a lower photoelectric conversion efficiency as compared to those including fullerenes.

### CITATION LIST

### - Patent Literature

Patent Literature 1: JP-A 2006-344794
Patent Literature 2: JP-B 4120362

### - Non Patent Literature

Non Patent Literature 1: Reese et al., Adv. Funct. Mater., 20, 3476-3483 (2010)

### SUMMARY OF INVENTION

### - Technical Problem

The present invention aims to provide an organic thin-film solar cell that has a high photoelectric conversion efficiency and excellent durability.

### - Solution to Problem

The present invention relates to an organic thin-film solar cell including a photoelectric conversion layer, wherein the photoelectric conversion layer includes a portion containing a sulfide of a Group 15 element in the periodic table and a portion containing a donor-acceptor organic semiconductor, and the portion containing a sulfide of a Group 15 element in the periodic table and the portion containing a donor-acceptor organic semiconductor are in contact with each other.

The present invention is described in detail below.

The inventors of the present invention found that, if an organic thin-film solar cell includes a photoelectric conversion layer that includes a portion containing a sulfide of a Group 15 element in the periodic table and a portion containing a donor-acceptor organic semiconductor, the organic thin-film solar cell has an enhanced durability while a high photoelectric conversion efficiency is maintained; and they completed the present invention.

The organic thin-film solar cell of the present invention includes a photoelectric conversion layer. The photoelectric conversion layer includes a portion containing a sulfide of a Group 15 element in the periodic table (hereinafter, also referred to as a "sulfide portion") and a portion containing a donor-acceptor organic semiconductor (hereinafter, also referred to as an "organic semiconductor portion"). Moreover, in the photoelectric conversion layer, the sulfide portion and the organic semiconductor portion are in contact with each other.

In the photoelectric conversion layer having the aforementioned structure, the sulfide portion and the organic semiconductor portion presumably act mainly as an N-type semiconductor and a P-type semiconductor, respectively. Photocarriers (electron-hole pair) are generated by photoexcitation in the P-type semiconductor or N-type semiconductor. Electrons move through the N-type semiconductor and holes move through the P-type semiconductor, thus creating an electric field. Meanwhile, the sulfide portion may partially act as a P-type semiconductor, and the organic semiconductor portion may partially act as an N-type semiconductor.

Due to high durability of sulfides of Group 15 elements in the periodic table, use of a sulfide of a Group 15 element in the periodic table enables the organic thin-film solar cell of the present invention to have excellent durability. In addition, due to the capability of the donor-acceptor organic semiconductor to absorb light in a long wavelength range, use of the donor-acceptor organic semiconductor enables the organic thin-film solar cell of the present invention to have a high photoelectric conversion efficiency. Moreover, use of the organic semiconductor enables the organic thin-film solar cell of the present invention to have excellent impact resistance, flexibility, and other properties as well.

The organic thin-film solar cell of the present invention including a combination of the sulfide portion and the organic semiconductor portion has an extremely high charge separation efficiency, and thus achieves a high photoelectric conversion efficiency. In the case where both of the N-type semiconductor and the P-type semiconductor are inorganic semiconductors, solid solutions thereof may form deposits on the interface. In contrast, deposits of solid solutions are not formed in the organic thin-film solar cell of the present invention. Thus, high stability can be achieved even at a high temperature.

The photoelectric conversion layer may have any structure as long as the sulfide portion and the organic semiconductor portion are in contact with each other. The photoelectric conversion layer may be a laminated body that includes a layer containing a sulfide portion (a layer containing a sulfide of a Group 15 element in the periodic table) and a layer containing an organic semiconductor portion (a layer containing a donor-acceptor organic semiconductor), or may be a composite film formed as a complex containing a mixture of a sulfide portion and an organic semiconductor portion. The photoelectric conversion layer is preferably a composite film because it can increase the charge separation efficiency of the donor-acceptor organic semiconductor.

The sulfide of a Group 15 element in the periodic table is preferably antimony sulfide or bismuth sulfide, and more preferably antimony sulfide. Antimony sulfide is very compatible with the donor-acceptor organic semiconductor in terms of the energy level. Moreover, it has higher visible light absorption than conventionally used materials such as zinc oxide or titanium oxide. Thus, if antimony sulfide is used as the sulfide of a Group 15 element in the periodic table, the organic thin-film solar cell has a higher photoelectric conversion efficiency. The sulfide of a Group 15 element in the periodic table may be used alone, or two or more kinds thereof may be used in combination.

The sulfide of a Group 15 element in the periodic table may be a complex sulfide in which two or more kinds of Group 15 elements in the periodic table are present in the same molecule.

The sulfide portion may contain other elements that do not impair the effects of the present invention in addition to the sulfide of a Group 15 element in the periodic table. Such other elements are not particularly limited, but are preferably any of the elements of fourth, fifth and sixth periods in the periodic table. Specific examples thereof include indium, gallium, tin, cadmium, copper, zinc, aluminum, nickel, silver, titanium, vanadium, niobium, molybdenum, tantalum, iron, and cobalt. Any of these other elements may be used alone, or two or more kinds thereof may be used in combination. Indium, gallium, tin, cadmium, zinc, or copper is especially preferable as the use thereof enhances the electron mobility.

The amount of other elements is preferably 50% by weight at the maximum in the sulfide portion. If the amount is not more than 50% by weight, the sulfide portion can maintain compatibility with the donor-acceptor organic semiconductor, thus increasing the photoelectric conversion efficiency.

The sulfide portion is preferably a crystalline semiconductor. If the sulfide portion is a crystalline semiconductor, the electron mobility is enhanced, thus increasing the photoelectric conversion efficiency.

The crystalline semiconductor refers to a semiconductor whose scattering peaks can be detected by X-ray diffraction measurement or other techniques.

The degree of crystallinity may be employed as an index of the crystallinity of the sulfide portion. The degree of crystallinity of the sulfide portion is preferably 30% at the minimum. If the degree of crystallinity is not less than 30%, the electron mobility is enhanced, thus increasing the photoelectric conversion efficiency. The minimum degree of crystallinity is more preferably 50%, and still more preferably 70%.

The degree of crystallinity can be determined as follows: scattering peaks of a crystalline fraction detected by X-ray diffraction measurement or other techniques, and halo due to an amorphous fraction are separated by fitting; integrated intensities thereof are determined; and the proportion of the crystalline fraction in the whole is calculated.

In order to increase the degree of crystallinity of the sulfide portion, the sulfide portion may be subjected to, for example, thermal annealing, exposure to strong light such as laser or flash lamp, exposure to excimer light, or exposure to plasma. Exposure to strong light or exposure to plasma, for example, is especially preferable as such a technique enables to suppress oxidation of the sulfide of a Group 15 element in the periodic table.

Examples of the donor-acceptor organic semiconductor include a low molecular weight compound containing a donor and an acceptor that are conjugated to each other in one molecule (hereinafter, such a compound is also simply referred to as a "low molecular weight compound"), and a conductive polymer containing a segment as a donor and a segment as an acceptor that are conjugated to each other (hereinafter, such a compound is also simply referred to as a "conductive polymer").

The donor refers to a skeleton having an electron-donating property with respect to the acceptor, and the acceptor is a skeleton having an electron-withdrawing property with respect to the donor. In other words, the HOMO and LUMO levels of the donor are relatively higher than those of the acceptor, and the HOMO and LUMO levels of the acceptor are relatively lower than those of the donor.

In addition, the phrase "a donor and an acceptor that are conjugated to each other" means that a donor segment and an acceptor segment are bonded together by or through conjugated bonds.

Examples of the structure capable of functioning as a donor in the low molecular weight compound include thiophene, fluorene, carbazole, and phenylenevinylene skeletons. Among these, the thiophene skeleton is preferred because it has excellent electrical conductivity, thus increasing the photoelectric conversion efficiency.

Examples of the thiophene skeleton include alkylthiophene, alkoxythiophene, thienothiophene, dithienothiophene, ethylenedioxythiophene, cyclopentadithiophene, and dithienosilole skeletons.

The structure capable of functioning as an acceptor in the low molecular weight compound is not particularly limited as long as the HOMO and LUMO levels are relatively smaller than those of the structure that functions as a donor. Preferred examples thereof include thienothiophene, dithienothiophene, benzothiadiazole, benzobisthiadiazole, thienopyridine, and diketopyrrolopyrrole skeletons.

The donor and the acceptor are not limited as long as they are conjugated to each other in one molecule of the low molecular weight compound. In other words, the donor and the acceptor may be adjacent to each other, or a group such as an optionally branched alkyl or arylene group having at least two carbon atoms may be present between the donor and the acceptor as long as the donor and the acceptor can be conjugated to each other.

The low molecular weight compound preferably contains a heterocyclic skeleton in the molecule. The heterocyclic skeleton improves the molecular orientation, thus enhancing the electric-charge mobility. For further improving the orientation, the low molecular weight compound more preferably contains a sulfur-containing heterocyclic skeleton, and still more preferably contains at least two sulfur-containing heterocyclic skeletons in the molecule.

Specific examples of the low molecular weight compound include compounds represented by the following formulae (1), (2), and (3).

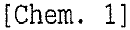

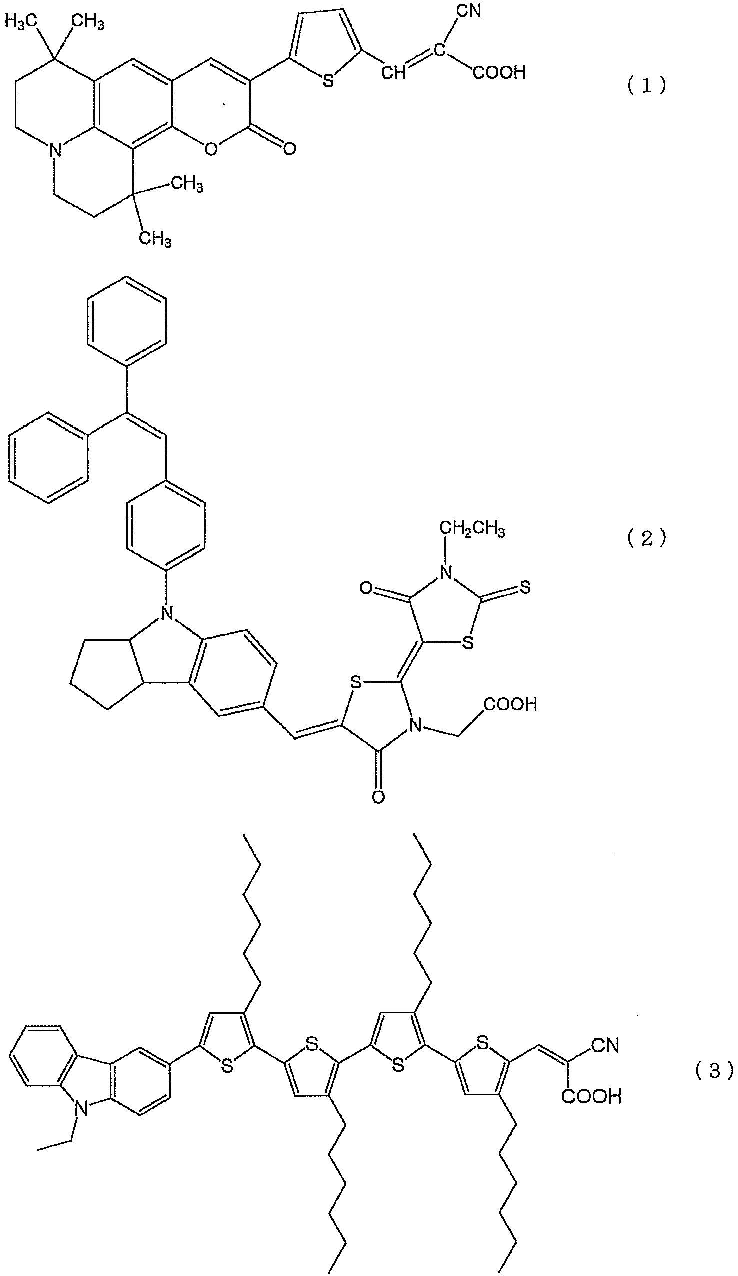

The compound represented by formula (1) has a structure in which a coumarin derivative as a donor and a cyano group-containing thiophene derivative as an acceptor are conjugated to each other. Examples of commercially available compounds represented by formula (1) include NKX-2587 produced by Hayashibara Biochemical Laboratories Inc.

The compound represented by formula (2) has a structure in which an indoline derivative as a donor and a thiazole derivative as an acceptor are conjugated to each other. Examples of commercially available compounds represented by formula (2) include D-149 produced by Mitsubishi Paper Mills Ltd.

The compound represented by formula (3) has a structure in which a carbazole structure as a donor and a cyano group-containing thiophene derivative as an acceptor are conjugated to each other. Examples of commercially available compounds represented by formula (3) include SK-II produced by Soken Chemical & Engineering Co., Ltd.

The conductive polymer includes repeating units of a segment as a donor and a segment as an acceptor.

The ratio of the segment as a donor to the segment as an acceptor (segment as a donor : segment as an acceptor) is preferably 7:1 to 1:2. If the proportion of the segment as a donor is greater than the above range, the light absorption in a long wavelength range may be reduced. If the proportion of the segment as an acceptor is greater than the above range, the electric-charge mobility may be reduced, leading to poor performance of the resulting photoelectric conversion element. A ratio of the segment as a donor to the segment as an acceptor (segment as a donor : segment as an acceptor) is more preferably 5:1 to 1:1.

In addition, the segment as a donor and the segment as an acceptor are preferably alternately arranged because such an arrangement increases the photoelectric conversion efficiency.

The segment as a donor preferably contains a heterocyclic skeleton. The heterocyclic skeleton improves the segment orientation, thus enhancing the electric-charge mobility. This increases the photoelectric conversion efficiency. For further improving the orientation, the segment as a donor more preferably contains a sulfur-containing heterocyclic skeleton.

Specific examples of the segment as a donor include segments represented by the following formulae (a) to (g). Among these, the segments represented by formulae (a), (b), (c), (d), and (e) are preferred because these segments have high electric-charge mobility, thus increasing the photoelectric conversion efficiency.

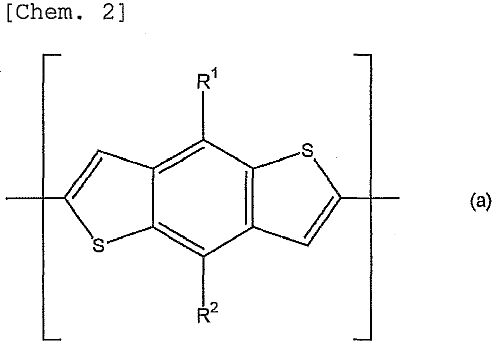

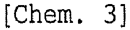

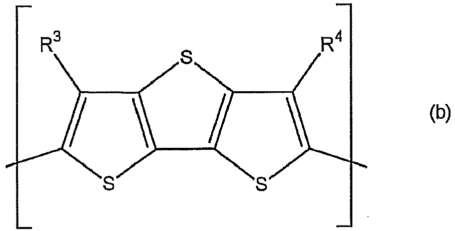

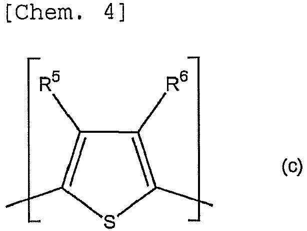

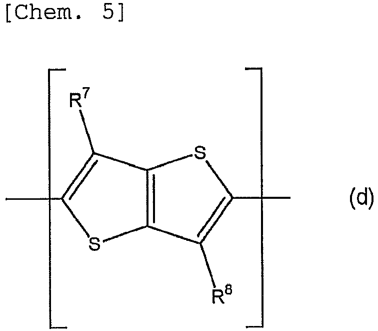

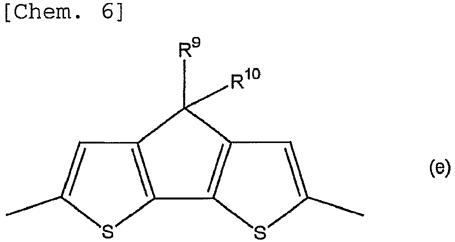

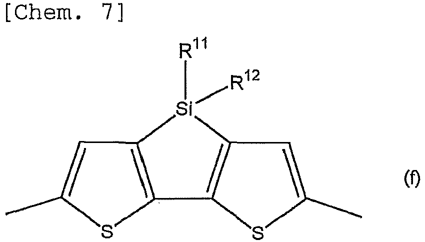

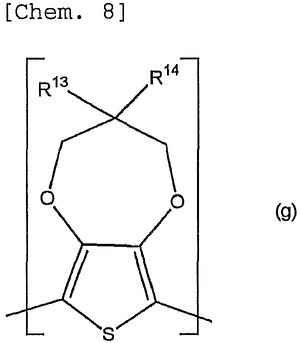

In formulae (a) to (g), R¹ to R¹⁴ each represent a hydrogen atom or a substituent.

The substituent may be a functional group containing a polar group or may be a non-polar group. Examples of the polar group include a carboxyl group, an ester group, a carbonyl group, an amino group, a hydroxyl group, a sulfonic acid group, a thiol group, a cyano group, a fluoro group, a chloro group, and a bromo group. Among these, a carboxyl group, an ester group, a carbonyl group, and a hydroxyl group are preferred because these groups are easy to synthesize. Examples of the non-polar group include an alkyl group having 1 to 16 carbon atoms, an aryl group, an alkoxy group, an alkenyl group, an alkynyl group, an aralkyl group, and a heteroaryl group.

The segment as an acceptor also preferably contains a heterocyclic skeleton because it improves the segment orientation, thus enhancing the electric-charge mobility. For further improving the orientation, the segment as an acceptor more preferably contains a sulfur- and/or nitrogen-containing heterocyclic skeleton.

Specific examples of the segment as an acceptor include segments represented by the following formulae (h) to (r). Among these, the segments represented by formulae (h), (i), (j), (n), and (q) are preferred because these segments have high electric-charge mobility, thus increasing the photoelectric conversion efficiency.

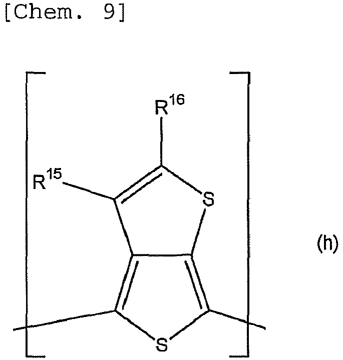

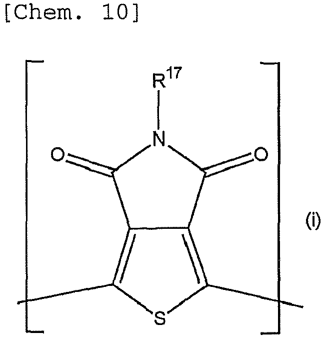

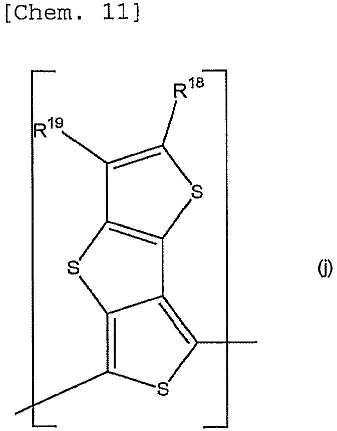

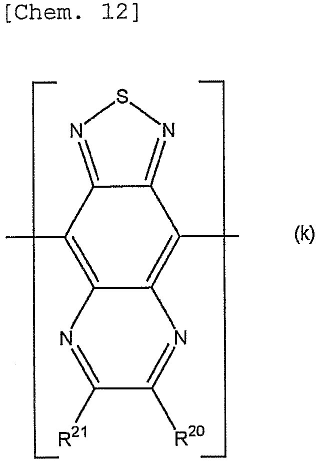

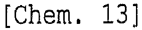

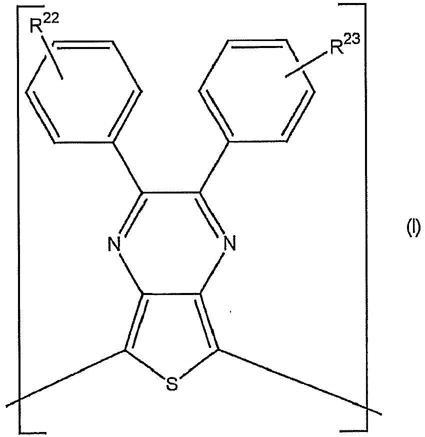

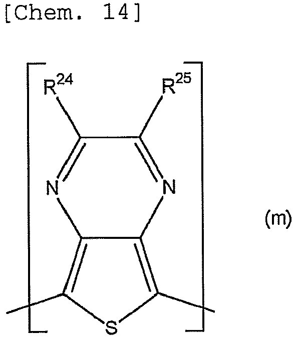

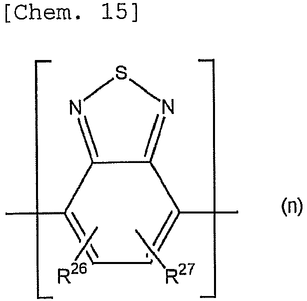

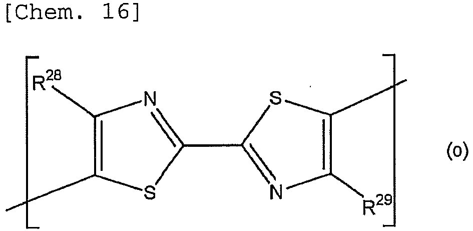

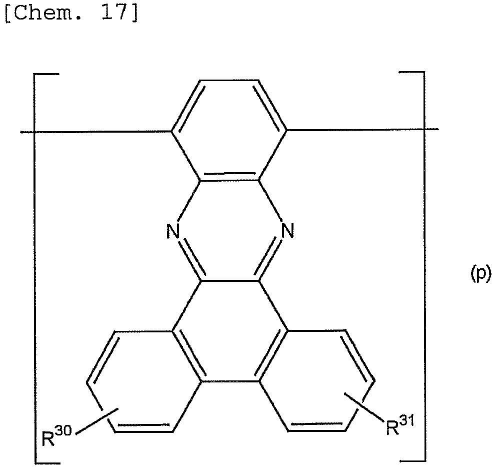

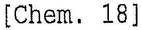

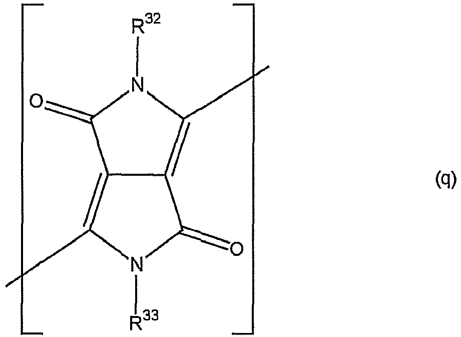

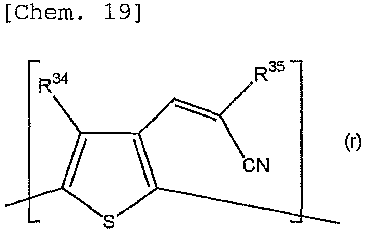

In formulae (h) to (r), R¹⁵ to R³⁵ each represent a hydrogen atom or a substituent.

The substituent may be a functional group containing a polar group or may be a non-polar group. Examples of the polar group include a carboxyl group, an ester group, a carbonyl group, an amino group, a hydroxyl group, a sulfonic acid group, a thiol group, a cyano group, a fluoro group, a chloro group, and a bromo group. Among these, a carboxyl group, an ester group, a carbonyl group, and a hydroxyl group are preferred because these groups are easy to synthesize. Examples of the non-polar group include an alkyl group having 1 to 16 carbon atoms, an aryl group, an alkoxy group, an alkenyl group, an alkynyl group, an aralkyl group, and a heteroaryl group.

In formula (q) , R³² and R³³ each represent a hydrogen atom or a substituent. At least one of R³² and R³³ is preferably a functional group containing a polar group.

Among the conductive polymers mentioned above, donor-acceptor polythiophene derivatives are more preferred. Among the donor-acceptor polythiophene derivatives, a thiophene-diketopyrrolopyrrole polymer is particularly preferred in terms of light absorption wavelength. The thiophene-diketopyrrolopyrrole polymer is a polymer in which the combination of the segment as a donor and the segment as an acceptor consists of the segment represented by formula (c) and the segment represented by formula (q), respectively.

Preferred examples of the combination of the segment as a donor and the segment as an acceptor include a combination of the segment represented by formula (a) and the segment represented by formula (h), a combination of the segment represented by formula (d) and the segment represented by segment (i), and a combination of the segment represented by formula (e) and the segment represented by formula (n) because the polymers having these combinations have excellent electrical conductivity, thus increasing the photoelectric conversion efficiency.

The number average molecular weight of the conductive polymer is preferably 3, 000 at the minimum and 1, 000, 000 at the maximum. The conductive polymer with a number average molecular weight of not less than 3, 000 has high electric-charge mobility, thus increasing the photoelectric conversion efficiency. The conductive polymer with a number average molecular weight of not more than 1,000,000 has excellent solubility in a solvent and good film-forming properties. The number average molecular weight is more preferably 5, 000 at the minimum and 700,000 at the maximum.

The number average molecular weight can be measured with gel permeation chromatography in chloroform at 40°C, and calculated based on standard polystyrene.

Examples of the method for producing the conductive polymer are not particularly limited but include copolymerizing a monomer constituting the segment as a donor with a monomer constituting the segment as an acceptor.

The organic thin-film solar cell of the present invention preferably includes the aforementioned photoelectric conversion layer between a pair of electrodes. The materials of the electrodes are not particularly limited, and may be conventional materials. Examples of the materials of the anode include metals such as gold, conductive transparent materials such as CuI, ITO (indium tin oxide), SnO₂, AZO (aluminum zinc oxide), IZO (indium zinc oxide), or GZO (gallium zinc oxide), and conductive transparent polymers. Examples of the materials of the cathode include sodium, sodium-potassium alloys, lithium, magnesium, aluminum, magnesium-silver mixtures, magnesium-indium mixtures, aluminum-lithium alloys, Al/Al₂O₃ mixtures, and Al/LiF mixtures. Any of these materials may be used alone, or two or more kinds thereof may be used in combination.

The organic thin-film solar cell of the present invention may further include a substrate, a hole transport layer, an electron transport layer, or other members. The substrate is not particularly limited, and examples thereof include transparent glass substrates such as soda-lime glass or alkali-free glass, ceramic substrates, and transparent plastic substrates.

The materials of the hole transport layer are not particularly limited. Examples of the materials include P-type conductive polymers, P-type low molecular weight organic semiconductors, P-type metal oxides, P-type metal sulfides, and surfactants. Specific examples thereof include polystyrene sulfonate-doped polyethylene dioxythiophene, carboxyl group-containing polythiophene, phthalocyanine, porphyrin, molybdenum oxide, vanadium oxide, tungsten oxide, nickel oxide, copper oxide, tin oxide, molybdenum sulfide, tungsten sulfide, copper sulfide, tin sulfide or the like, fluoro group-containing phosphonic acid, and carbonyl group-containing phosphonic acid.

The materials of the electron transport layer are not particularly limited. Examples of the materials include N-type conductive polymers, N-type low molecular weight organic semiconductors, N-type metal oxides, N-type metal sulfides, alkali metal halides, alkali metals, and surfactants. Specific examples thereof include cyano group-containing polyphenylene vinylene, boron-containing polymers, bathocuproine, bathophenanthroline, hydroxy quinolinato aluminum, oxadiazol compounds, benzoimidazole compounds, naphthalene tetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, and zinc sulfide.

In particular, the organic thin-film solar cell of the present invention preferably includes a photoelectric conversion layer that is a laminated body including a layer containing a sulfide portion (a layer containing a sulfide of a Group 15 element in the periodic table) and a layer containing an organic semiconductor portion (a layer containing a donor-acceptor organic semiconductor) between a pair of electrodes, and further comprises an electron transport layer between one of the electrodes and the later containing a sulfide portion. The organic thin-film solar cell of the present invention more preferably includes an electron transport layer between one of the electrodes and the layer containing a sulfide portion and a hole transport layer between the other electrode and the layer containing an organic semiconductor portion.

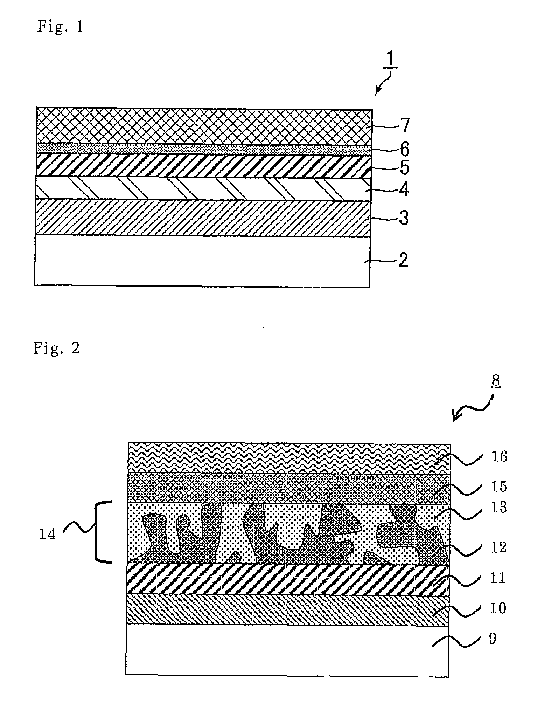

Fig. 1 shows a schematic view of one example of the organic thin-film solar cell of the present invention in which the photoelectric conversion layer is a laminated body. In an organic thin-film solar cell 1 shown in Fig. 1, a substrate 2, a transparent electrode (anode) 3, a layer 4 containing an organic semiconductor portion (a layer containing a donor-acceptor organic semiconductor), a layer 5 containing a sulfide portion (a layer containing a sulfide of a Group 15 element in the periodic table), an electron transport layer 6, and an electrode (cathode) 7 are laminated in this order.

Preferably, the organic thin-film solar cell of the present invention includes a photoelectric conversion layer that is a composite film formed as a complex containing a mixture of a sulfide portion and an organic semiconductor portion between a pair of electrodes, and further includes an electron transport layer between one of the electrodes and the photoelectric conversion layer. Moreover, the organic thin-film solar cell of the present invention more preferably includes an electron transport layer between one of the electrodes and the photoelectric conversion layer, and a hole transport layer between the other electrode and the photoelectric conversion layer.

Fig. 2 shows a schematic view of one example of the organic thin-film solar cell of the present invention in which the photoelectric conversion layer is a composite film. In an organic thin-film solar cell 8 shown in Fig. 2, a substrate 9, a transparent electrode (anode) 10, a hole transport layer 11, a composite film 14 including an organic semiconductor portion 12 and a sulfide portion 13, an electron transport layer 15, and an electrode (cathode) 16 are laminated in this order.

In the case where the photoelectric conversion layer is a laminated body, the layer containing a sulfide portion preferably has a minimum thickness of 5 nm and a maximum thickness of 5,000 nm. The layer containing a sulfide portion having a thickness of not smaller than 5 nm can more sufficiently absorb light, thus increasing the photoelectric conversion efficiency. The layer containing a sulfide portion having a thickness of not larger than 5,000 nm can prevent generation of regions where charge separation does not occur, thus preventing a reduction in the photoelectric conversion efficiency. The layer containing a sulfide portion more preferably has a minimum thickness of 10 nm and a maximum thickness of 1,000 nm, and still more preferably has a minimum thickness of 20 nm and a maximum thickness of 500 nm.

In the case where the photoelectric conversion layer is a laminated body, the layer containing an organic semiconductor portion preferably has a minimum thickness of 5 nm and a maximum thickness of 1,000 nm. The layer containing an organic semiconductor portion having a thickness of not smaller than 5 nm can more sufficiently absorb light, thus increasing the photoelectric conversion efficiency. The layer containing an organic semiconductor portion having a thickness of not larger than 1,000 nm can prevent generation of regions where charge separation does not occur, thus preventing a reduction in the photoelectric conversion efficiency. The layer containing an organic semiconductor portion more preferably has a minimum thickness of 10 nm and a maximum thickness of 500 nm, and still more preferably has a minimum thickness of 20 nm and a maximum thickness of 200 nm.

The hole transport layer preferably has a minimum thickness of 1 nm and a maximum thickness of 200 nm. The hole transport layer having a thickness of not smaller than 1 nm can more sufficiently block electrons. The hole transport layer having a thickness of not larger than 200 nm tends not to create resistance to hole transport, thus increasing the photoelectric conversion efficiency. The hole transport layer more preferably has a minimum thickness of 3 nm and a maximum thickness of 150 nm, and still more preferably has a minimum thickness of 5 nm and a maximum thickness of 100 nm.

The electron transport layer preferably has a minimum thickness of 1 nm and a maximum thickness of 200 nm. The electron transport layer having a thickness of not smaller than 1 nm can more sufficiently block holes. The electron transport layer having a thickness of not larger than 200 nm tends not to create resistance to electron transport, thus increasing the photoelectric conversion efficiency. The electron transport layer more preferably has a minimum thickness of 3 nm and a maximum thickness of 150 nm, and still more preferably has a minimum thickness of 5 nm and a maximum thickness of 100 nm.

In the case where the photoelectric conversion layer is a composite film as mentioned above, the photoelectric conversion layer preferably has a minimum thickness of 30 nm and a maximum thickness of 3,000 nm. The photoelectric conversion layer having a thickness of not smaller than 30 nm can more sufficiently absorb light, thus increasing the photoelectric conversion efficiency. The photoelectric conversion layer having a thickness of not larger than 3000 nm enables electric charge to be easily transferred to the electrodes, thus increasing the photoelectric conversion efficiency. The photoelectric conversion layer more preferably has a minimum thickness of 40 nm and a maximum thickness of 1,000 nm, and still more preferably has a minimum thickness of 50 nm and a maximum thickness of 500 nm.

In the case where the photoelectric conversion layer is a composite film, the ratio between the sulfide portion and the organic semiconductor portion is very important. The ratio between the sulfide portion and the organic semiconductor portion is preferably 1: 9 to 9:1 (volume ratio). If the ratio is within the above range, holes or electrons easily reach the electrodes, thus increasing the photoelectric conversion efficiency. The ratio is more preferably 2:8 to 8:2 (volume ratio).

The method for producing the organic thin-film solar cell of the present invention is not particularly limited. For example, in the case where the photoelectric conversion layer is a laminated body, the organic thin-film solar cell of the present invention is produced by the following method: an electrode (anode) is formed on a substrate; a layer containing an organic semiconductor portion is formed on a surface of the electrode (anode) by a printing method such as spin coating; then a layer containing a sulfide portion is formed on a surface of the layer containing an organic semiconductor portion by vacuum evaporation or another method; and further, an electrode (cathode) is formed on a surface of the layer containing a sulfide portion. Alternatively, after an electrode (cathode) is formed on a substrate, a layer containing a sulfide portion, a layer containing an organic semiconductor portion, and an electrode (anode) may be formed in this order.

In the production of the organic thin-film solar cell of the present invention, a layer containing an organic semiconductor portion can be stably and simply formed by a printing method such as spin coating, and thus the cost for forming a layer containing an organic semiconductor portion can be reduced. A layer containing a sulfide portion may also be formed not by vacuum evaporation but by printing such as spin coating from a solution of a precursor of a sulfide of a Group 15 element in the periodic table or a dispersion of sulfide nanoparticles of a Group 15 element in the periodic table.

Moreover, in the case where the photoelectric conversion layer is a composite film, for example, the composite film may be formed of a mixture of a donor-acceptor organic semiconductor and a solution of a precursor of a sulfide of a Group 15 element in the periodic table or a dispersion of sulfide nanoparticles of a Group 15 element in the periodic table. Furthermore, the composite film may also be formed by co-deposition of a sulfide of a Group 15 element in the periodic table and an organic semiconductor.

### - Advantageous Effects of Invention

The present invention provides an organic thin-film solar cell that has a high photoelectric conversion efficiency and excellent durability.

### BRIEF DESCRIPTION OF DRAWINGS

Fig. 1 is a cross-sectional view schematically showing one example of the organic thin-film solar cell of the present invention in which the photoelectric conversion layer is a laminated body.
Fig. 2 is a cross-sectional view schematically showing one example of the organic thin-film solar cell of the present invention in which the photoelectric conversion layer is a composite film.

### DESCRIPTION OF EMBODIMENTS

The present invention is described in more detail below referring to, but not limited to, examples.

The following Examples 1 to 5 and Comparative Examples 1 to 16 each describe the production of an organic thin-film solar cell in which a photoelectric conversion layer is a laminated body.

### (Example 1)

### <Cathode>

An ITO film having a thickness of 240 nm was formed as a cathode on a glass substrate. The ITO film was subjected to ultrasonic cleaning for 10 minutes each with acetone, methanol, and isopropyl alcohol in this order, followed by drying.

### <Electron transport layer>

An electron transport layer having a thickness of 50nm was formed using a zinc oxide nanoparticle dispersion by spin coating on a surface of the ITO film.

### <Photoelectric conversion layer (laminated body)>

An antimony sulfide layer having a thickness of 40 nm was formed by vacuum evaporation as a layer containing a sulfide portion (acting mainly as an N-type semiconductor) on a surface of the electron transport layer, and then annealed at a temperature of 260°C for 2 minutes. Further, a donor-acceptor conductive polymer (PBDTTT-CF, produced by 1-Material) layer having a thickness of 40 nm was formed by spin coating as a layer containing an organic semiconductor portion (acting mainly as a P-type semiconductor) on a surface of the layer containing a sulfide portion.

### <Hole transport layer>

A poly(3,4-ethylene dioxythiophene):poly(styrene sulfonate) (PEDOT:PSS) layer having a thickness of 50 nm was formed by spin coating as a hole transport layer on a surface of the layer containing an organic semiconductor portion.

### <Anode>

A gold film having a thickness of 100 nm was formed by vacuum evaporation as an anode on a surface of the hole transport layer. Thus, an organic thin-film solar cell was obtained.

### (Example 2)

An organic thin-film solar cell was produced in the same manner as in Example 1, except that bismuth sulfide was used instead of antimony sulfide.

### (Example 3)

An organic thin-film solar cell was produced in the same manner as in Example 1, except that another donor-acceptor conductive polymer (PCPDTBT, produced by Aldrich) was used instead of the above donor-acceptor conductive polymer (PBDTTT-CF, produced by 1-Material).

### (Example 4)

An organic thin-film solar cell was produced in the same manner as in Example 1, except that the annealing temperature for forming the layer containing a sulfide portion was changed to 240°C.

### (Example 5)

An organic thin-film solar cell was produced in the same manner as in Example 1; except that another donor-acceptor conductive polymer (thiophene-diketopyrrolopyrrole polymer) was used instead of the above donor-acceptor conductive polymer (PBDTTT-CF, produced by 1-Material). The thiophene-diketopyrrolopyrrole polymer was synthesized as follows.

### <Synthesis of thiophene-diketopyrrolopyrrole polymer>

To a nitrogen-purged 50-mL schlenk flask equipped with a stirrer were introduced 250 mg (0.32 mmol) of 3,6-di(2-thienyl)-2,5-dihydropyrrolo[3,4-c]pyrrole-1,4-dion e, 171 mg (0.96 mmol) of N-bromosuccinimide, and 10 mL of dichloromethane. Then, the mixture was reacted at room temperature for 48 hours under nitrogen atmosphere. After reaction, water was added to the resulting solution, whereby an organic phase was separated out. Magnesium sulfate was added to dry the organic phase, which was then concentrated under reduced pressure. Subsequently, a diketopyrrolopyrrole monomer was obtained by chromatography on amino-modified silica gel using an eluent containing a 1:1 mixture of chloroform and hexane.

Next, to a nitrogen-purged 25-mL schlenk flask equipped with a stirrer were introduced 59.8 mg (0.063 mmol) of diketopyrrolopyrrole monomer, 11.0 mg (0.064 mmol) of 2, 5-thiophenediboronic acid as a monomer containing a thiophene skeleton, 59.2 µL of Aliquat 336, 59.2 µL of toluene, and 1.6 mg (6.2 µmol) of triphenylphosphine (PPh₃). To the above mixture was added a mixture (provided in a sample bottle) consisting of a solution (0.12 mL) of 67.4 mg (0.32 mmol) of tripotassium phosphate (K₃PO₄) in distilled water and 1.1 mL of toluene, followed by nitrogen bubbling for 5 minutes. Then, 2. 4 mg (2.6 µmol) of tris (dibenzylideneacetone) dipalladium (0) (Pd₂(dba)₃) was added, and the mixture was heated to 115°C under nitrogen atmosphere and reacted at the same temperature for 72 hours. Subsequently, the reaction solution was cooled to room temperature and introduced to 500 mL of methanol to deposit a polymer.

The deposited polymer was separated by filtration and dissolved again in 25 mL of chloroform. To the resulting solution was added 25 mL of ammonia water, followed by stirring for 3 hours. Subsequently, an organic phase was separated out. Then, 75 mg of ethylenediaminetetraacetic acid (EDTA) was added to the organic phase, followed by stirring at room temperature for 16 hours. Subsequently, 25 mL of water was added, followed by stirring for 12 hours. Next, the organic phase was again separated out, and the solvent was removed by evaporation under reduced pressure. The resulting dried solid was then dissolved in about 1 mL of chloroform. The solution was introduced again to 500 mL of methanol to thereby deposit a polymer. The deposited polymer was separated by filtration, and then washed with methanol, water, and hexane in this order, followed by drying under reduced pressure, thus obtaining a thiophene-diketopyrrolopyrrole polymer (blackish blue, solid, 32.4 mg).

The yield of the obtained polymer was 60% relative to the diketopyrrolopyrrole derivative used. The obtained polymer had a number average molecular weight of 4,000, and a weight average molecular weight of 8,100. The number average molecular weight and the weight average molecular weight were measured with a gel permeation chromatography device (HLC-8020, produced by Tosoh Corporation) in chloroform at 40°C, and calculated based on standard polystyrene.

### (Comparative Example 1)

### <Anode>

An ITO film having a thickness of 240 nm was formed as an anode on a glass substrate. The ITO film was subjected to ultrasonic cleaning for 10 minutes each with acetone, methanol, and isopropyl alcohol in this order, followed by drying.

### <Photoelectric conversion layer (laminated body)>

A polyethylene dioxide thiophene:polystyrene sulfonate (PEDOT:PSS) layer having a thickness of 50 nm was formed by spin coating as a layer containing an organic semiconductor portion on a surface of an ITO film. Then, an antimony sulfide layer having a thickness of 40 nm was formed by vacuum evaporation as a layer containing a sulfide portion on a surface of the layer containing an organic semiconductor portion.

### <Electron transport layer>

An electron transport layer having a thickness of 50nm was formed using a zinc oxide nanoparticle dispersion by spin coating on a surface of the layer containing a sulfide portion. The layer was annealed at a temperature of 260°C for 2 minutes.

### <Cathode>

An aluminum film having a thickness of 100 nm was formed by vacuum evaporation as a cathode on a surface of the electron transport layer. Thus, an organic thin-film solar cell was obtained.

### (Comparative Example 2)

An organic thin-film solar cell was produced in the same manner as in Example 1, except that poly (3-hexylthiophene) was used instead of the donor-acceptor conductive polymer (PBDTTT-CF, produced by 1-Material).

### (Comparative Example 3)

### <Cathode>

An ITO film having a thickness of 240 nm was formed as a cathode on a glass substrate. The ITO film was subjected to ultrasonic cleaning for 10 minutes each with acetone, methanol, and isopropyl alcohol in this order, followed by drying.

### <Photoelectric conversion layer (laminated body)>

An antimony sulfide layer having a thickness of 40 nm was formed by vacuum evaporation as a layer containing a sulfide portion on a surface of the ITO film, and then annealed at a temperature of 260°C for 2 minutes. Further, a poly(3-hexylthiophene) layer having a thickness of 40 nm was formed by spin coating as a layer containing an organic semiconductor portion on a surface of the layer containing a sulfide portion.

### <Hole transport layer>

A polyethylene dioxide thiophene:polystyrene sulfonate (PEDOT:PSS) layer having a thickness of 50 nm was formed by spin coating as a hole transport layer on a surface of the layer containing an organic semiconductor portion.

### <Anode>

A gold film having a thickness of 100 nm was formed by vacuum evaporation as an anode on a surface of the hole transport layer. Thus, an organic thin-film solar cell was obtained.

### (Comparative Example 4)

An organic thin-film solar cell was produced in the same manner as in Comparative Example 2, except that bismuth sulfide was used instead of antimony sulfide.

### (Comparative Example 5)

An organic thin-film solar cell was produced in the same manner as in Comparative Example 2, except that the annealing temperature for forming the layer containing a sulfide portion was changed to 240°C.

### (Comparative Example 6)

An organic thin-film solar cell was produced in the same manner as in Comparative Example 2, except that the annealing temperature for forming the layer containing a sulfide portion was changed to 200°C.

### (Comparative Example 7)

An organic thin-film solar cell was produced in the same manner as in Comparative Example 2, except that copper phthalocyanine was used instead of poly(3-hexylthiophene) to form a layer having a thickness of 30 nm by evaporation.

### (Comparative Example 8)

An organic thin-film solar cell was produced in the same manner as in Comparative Example 2, except that a fullerene was used instead of antimony sulfide.

### (Comparative Example 9)

An organic thin-film solar cell was produced in the same manner as in Comparative Example 8, except that the annealing temperature for forming a fullerene layer was changed to 180°C.

### (Comparative Example 10)

An organic thin-film solar cell was produced in the same manner as in Comparative Example 8, except that a fullerene layer was formed without annealing.

### (Comparative Example 11)

An organic thin-film solar cell was produced in the same manner as in Comparative Example 2, except that zinc oxide nanoparticles were used instead of antimony sulfide to form a layer by spin coating.

### (Comparative Example 12)

An organic thin-film solar cell was produced in the same manner as in Comparative Example 2, except that tin sulfide was used instead of antimony sulfide.

### (Comparative Example 13)

An organic thin-film solar cell was produced in the same manner as in Comparative Example 2, except that zinc sulfide nanoparticles were used instead of antimony sulfide to form a layer by spin coating.

### (Comparative Example 14)

An organic thin-film solar cell was produced in the same manner as in Comparative Example 1, except that copper sulfide was used instead of PEDOT:PSS to form a layer by vacuum evaporation.

### (Comparative Example 15)

An organic thin-film solar cell was produced in the same manner as in Example 1, except that tin sulfide was used instead of antimony sulfide.

### (Comparative Example 16)

An organic thin-film solar cell was produced in the same manner as in Example 1, except that indium sulfide was used instead of antimony sulfide.

The following Comparative Examples 17 to 19 each describe the production of an organic thin-film solar cell in which a photoelectric conversion layer is a composite film.

### (Comparative Example 17)

### <Anode>

An ITO film having a thickness of 240 nm was formed as an anode on a glass substrate. The ITO film was subjected to ultrasonic cleaning for 10 minutes each with acetone, methanol, and isopropyl alcohol in this order, followed by drying.

### <Hole transport layer>

A polyethylene dioxide thiophene:polystyrene sulfonate (PEDOT:PSS) layer having a thickness of 50 nm was formed by spin coating as a hole transport layer on a surface of the ITO film.

### <Photoelectric conversion layer (composite film)>

A total of 8 parts by weight of a fullerene derivative (PCBM, produced by American Dye Source, Inc.) and 10 parts by weight of poly(3-hexylthiophene) were dispersed and dissolved in chlorobenzene (600 parts by weight) to prepare a mixture. The mixture was applied to a surface of the hole transport layer to form a composite film having a thickness of 150 nm.

### <Electron transport layer>

An electron transport layer having a thickness of 50nm was formed using a zinc oxide nanoparticle dispersion by spin coating on a surface of the photoelectric conversion layer.

### <Cathode>

An aluminum film having a thickness of 100 nm was formed by vacuum evaporation as a cathode on a surface of the electron transport layer. Thus, an organic thin-film solar cell was obtained.

### (Comparative Example 18)

An organic thin-film solar cell was produced in the same manner as in Comparative Example 17, except that zinc oxide nanoparticles were used instead of a fullerene derivative.

### (Comparative Example 19)

An organic thin-film solar cell was produced in the same manner as in Comparative Example 17, except that zinc sulfide nanoparticles were used instead of a fullerene derivative.

### (Evaluation)

### (1) Measurement of photoelectric conversion efficiency

A power source (Model 236, produced by Keithley Instruments Inc.) was connected between electrodes of an organic thin-film solar cell. The photoelectric conversion efficiency of each organic thin-film solar cell was measured with a solar simulator (produced by Yamashita Denso Corporation) at an intensity of 100 mW/cm². The measured value was standardized based on the photoelectric conversion efficiency in Comparative Example 10 regarded as 1.00 (relative photoelectric conversion efficiency (a ratio relative to Comparative Example 10)).

### (2) Measurement of photoelectric conversion efficiency after weathering test

A weathering test was performed by glass sealing an organic thin-film solar cell, and exposing it to light at an intensity of 60 mW/cm² for 24 hours under a temperature of 60°C and a humidity of 35%. The photoelectric conversion efficiency was measured before and after the weathering test in the same manner as in (1) above to determine a relative conversion efficiency, which is a ratio of the photoelectric conversion efficiency after the weathering test relative to the initial photoelectric conversion efficiency (initial value) regarded as 1.00.

### (3) Measurement of long wavelength quantum efficiency

A quantum efficiency measurement system (produced by Bunkoukeiki Co., Ltd.) was used to measure the quantum efficiency of each organic thin-film solar cell. An organic thin-film solar cell showing a quantum efficiency curve that starts rising at a wavelength of 800 nm or longer was evaluated as "Good", and an organic thin-film solar cell showing a quantum efficiency curve that starts rising at a wavelength shorter than 800 nm was evaluated as "Poor".

### <Comprehensive evaluation>

Each cell was comprehensively evaluated according to the following criteria.
Poor: The relative photoelectric conversion efficiency (a ratio relative to Comparative Example 10) was not more than 1; the relative conversion efficiency after the weathering test (a ratio relative to the initial value) was not more than 0.8; or the measurement of the long wavelength quantum efficiency was evaluated as "Poor".
Good: The relative photoelectric conversion efficiency (a ratio relative to Comparative Example 10) was more than 1; the relative conversion efficiency after the weathering test (a ratio relative to the initial value) was more than 0.8; and the measurement of the long wavelength quantum efficiency was evaluated as "Good".

**[Table 1]**

| | | Example 1 | Example 2 | Example 3 | Example 4 | Example 5 |
|---|---|---|---|---|---|---|
| Electron transport layer | | Zinc oxide | Zinc oxide | Zinc oxide | Zinc oxide | Zinc oxide |
| Hole transport layer | | PEDOT:PSS | PEDOT:PSS | PEDOT:PSS | PEDOT:PSS | PEDOT: PSS |
| Photoelectric conversion layer (Laminated body) | N-type semiconductor | Antimony sulfide | Bismuth sulfide | Antimony sulfide | Antimony sulfide | Antimony sulfide |
| | P-type semiconductor | PEDTTT-CF | PEDTTT-CF | PCPDTBT | PEDTTT-CF | thiophene-diketopyrrolopyrrole polymer |
| Annealing temperature | | 260 | 260 | 260 | 240 | 260 |
| Evaluation | Relative photoelectric conversion efficiency (ratio relative to Comparative Example 10) | 6.4 | 4.2 | 6.6 | 3.6 | 6.6 |
| | Relative conversion efficiency after weathering test (24 hours) (ratio relative to initial value) | 0.9 | 0.9 | 0.9 | 0.9 | 0.9 |
| | Measurement of long wavelength quantum efficiency | Good | Good | Good | Good | Good |
| | Comprehensive evaluation | Good | Good | Good | Good | Good |

**[Table 2]**

| | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|
| Electron transport layer | | Zinc oxide | Zinc oxide | - | Zinc oxide | Zinc oxide | Zinc oxide | Zinc oxide |
| Hole transport layer | | - | PEDOT: PSS | PEDOT:PSS | PEDOT:PSS | PEDOT:PSS | PEDOT:PSS | PEDOT:PSS |
| Photoelectric conversion layer (Laminated body) | N-type semiconductor | Antimony sulfide | Antimony sulfide | Antimony sulfide | Bismuth sulfide | Antimony sulfide | Antimony sulfide | Antimony sulfide |
| | P-type semiconductor | PEDOT: PSS | Poly(3-hexylthiophene) | Poly(3-hexylthiophene) | Poly(3-hexylthiophene) | Poly(3-hexylthiophene) | Poly(3-hexylthiophene) | Copper phthalocyanine |
| Annealing temperature | | 260 | 260 | 260 | 260 | 240 | 200 | 260 |
| Evaluation | Relative photoelectric conversion efficiency (ratio relative to Comparative Example 10) | 42 | 5.8 | 3.8 | 3 | 3.2 | 2.4 | 4.6 |
| | Relative conversion efficiency after weathering test (24 hours) (ratio relative to initial value) | 0.9 | 1 | 1 | 1 | 1 | 1 | 1 |
| | Measurement of long wavelength quantum efficiency | Poor | Poor | Poor | Poor | Poor | Poor | Poor |
| | Comprehensive evaluation | Poor | Poor | Poor | Poor | Poor | Poor | Poor |

**[Table 3]**

| | | Comparative Example 8 | Comparative Example 9 | Comparative Example 10 | Comparative Example 11 | Comparative Example 12 | Comparative Example 13 | Comparative Example 14 | Comparative Example 15 | Comparative Example 16 |
|---|---|---|---|---|---|---|---|---|---|---|
| Electron transport layer | | Zinc oxide | Zinc oxide | Zinc oxide | Zinc oxide | Zinc oxide | Zinc oxide | Zinc oxide | Zinc oxide | Zinc oxide |
| Hole transport layer | | PEDOT:PSS | PEDOT:PSS | PEDOT:PSS | PEDOT:PSS | PEDOT:PSS | PEDOT:PSS | - | PEDOT:PSS | PEDOT:PSS |
| Photoelectric conversion layer (Laminated body) | N-type semiconductor | Fullerene | Fullerene | Fullerene | Zinc oxide | Tin sulfide | Zinc sulfide | Antimony sulfide | Tin sulfide | Indium sulfide |
| | P-type semiconductor | Poly(3-hexylthiophene) | Poly(3-hexylthiophene) | Poly(3-hexylthiophene) | poly(3-hexylthiophene) | Poly(3-hexylthiophene) | poly(3-hexylthiophene) | Copper sulfide | PBDTTT-CF | PBDTTT-CF |
| Annealing temperature | | 260 | 180 | - | 260 | 260 | 260 | 260 | 260 | 260 |
| Evaluation | Relative photoelectric conversion efficiency (ratio relative to Comparative Example 10) | 0.5 | 0.8 | 1 | 1 | 0.7 | 0.8 | 0.2 | 0.2 | 0.3 |
| | Relative conversion efficiency after weathering test (24 hours) (ratio relative to initial value) | 0.4 | 0.4 | 0.4 | 0.3 | 0.3 | 0.4 | 1 | 0.9 | 0.9 |
| | Measurement of long wavelength quantum efficiency | Poor | Poor | Poor | Poor | Poor | Poor | Poor | Good | Good |
| | Comprehensive evaluation | Poor | Poor | Poor | Poor | Poor | Poor | Poor | Poor | Poor |

**[Table 4]**

| | | Comparative Example 17 | Comparative Example 18 | Comparative Example 19 |
|---|---|---|---|---|
| Electron transport layer | | Zinc oxide | Zinc oxide | Zinc oxide |
| Hole transport layer | | PEDOT: PSS | PEDOT:PSS | PEDOT:PSS |
| Photoelectric conversion layer (Composite film) | N-type semiconductor | Fullerene derivative | Zinc oxide | Zinc sulfide |
| | P-type semiconductor | Poly(3-hexylthiophene) | Poly(3-hexylthiophene) | Poly(3-hexylthiophene) |
| Evaluation | Relative photoelectric conversion efficiency (ratio relative to Comparative Example 10) | 5.4 | 3.8 | 1 |
| | Relative conversion efficiency after weathering test (24 hours) (ratio relative to initial value) | 0.3 | 0.3 | 0.4 |
| | Measurement of long wavelength quantum efficiency | Poor | Poor | Poor |
| | Comprehensive evaluation | Poor | Poor | Poor |

### INDUSTRIAL APPLICABILITY

The present invention provides an organic thin-film solar cell that has a high photoelectric conversion efficiency and excellent durability.

### REFERENCE SIGNS LIST

- 1: Organic thin-film solar cell
- 2: Substrate
- 3: Transparent electrode (anode)
- 4: Layer containing an organic semiconductor portion (layer containing a donor-acceptor organic semiconductor)
- 5: Layer containing a sulfide portion (layer containing a sulfide of a Group 15 element in the periodic table)
- 6: Electron transport layer
- 7: Electrode (cathode)
- 8: Organic thin-film solar cell
- 9: Substrate
- 10: Transparent electrode (anode)
- 11: Hole transport layer
- 12: Organic semiconductor portion
- 13: Sulfide portion
- 14: Composite film
- 15: Electron transport layer
- 16: Electrode (cathode)

## Claims

1. An organic thin-film solar cell comprising a photoelectric conversion layer,
wherein the photoelectric conversion layer includes a portion containing a sulfide of a Group 15 element in the periodic table and a portion containing a donor-acceptor organic semiconductor, and
the portion containing a sulfide of a Group 15 element in the periodic table and the portion containing a donor-acceptor organic semiconductor are in contact with each other.

2. The organic thin-film solar cell according to claim 1,
wherein the sulfide of a Group 15 element in the periodic table is antimony sulfide.

3. The organic thin-film solar cell according to claim 1 or 2,
wherein the donor-acceptor organic semiconductor is a conductive polymer containing a segment as a donor and a segment as an acceptor that are conjugated to each other.

4. The organic thin-film solar cell according to claim 3,
wherein, in the conductive polymer containing a segment as a donor and a segment as an acceptor that are conjugated to each other, the segment as a donor and/or the segment as an acceptor contains a heterocyclic skeleton.

5. The organic thin-film solar cell according to claim 1, 2, 3, or 4
wherein the photoelectric conversion layer is a laminated body including a layer containing the sulfide of a Group 15 element in the periodic table and a layer containing the donor-acceptor organic semiconductor.

6. The organic thin-film solar cell according to claim 5,
wherein the photoelectric conversion layer that is a laminated body including a layer containing the sulfide of a Group 15 element in the periodic table and a layer containing the donor-acceptor organic semiconductor is disposed between a pair of electrodes, and
the organic thin-film solar cell further comprises an electron transport layer between one of the electrodes and the layer containing the sulfide of a Group 15 element in the periodic table, and a hole transport layer between the other electrode and the layer containing the donor-acceptor organic semiconductor.

7. The organic thin-film solar cell according to claim 1, 2, 3, or 4,
wherein the photoelectric conversion layer is a composite film formed as a complex containing a mixture of the portion containing a sulfide of a Group 15 element in the periodic table and the portion containing a donor-acceptor organic semiconductor.

8. The organic thin-film solar cell according to claim 7,
wherein the photoelectric conversion layer that is a composite film formed as a complex containing a mixture of the portion containing a sulfide of a Group 15 element in the periodic table and the portion containing a donor-acceptor is disposed between a pair of electrodes, and
the organic thin-film solar cell further comprises an electron transport layer between one of the electrodes and the photoelectric conversion layer and a hole transport layer between the other electrode and the photoelectric conversion layer.
